# EUROPEAN PATENT SPECIFICATION

(11) **EP 0 577 998 B1**
(45) Date of publication and mention of the grant of the patent: **18.03.1998**
(21) Application number: 93109418.9
(22) Date of filing: 11.06.1993
(51) Int. Cl.: H01L 29/76, H01L 29/40

(54) **Field effect transistor**
Feldeffekttransistor
Transistor à effet de champ

(30) Priority: 12.06.1992 JP 179429/92
(43) Date of publication of application: 12.01.1994
(73) Proprietor: YOZAN INC., Tokyo 155 (JP); SHARP KABUSHIKI KAISHA, Osaka 545 (JP)
(72) Inventor: Shou, Guoliang, c/o YOZAN Inc., Tokyo 155 (JP); Takatori, Sunao, c/o YOZAN Inc., Tokyo 155 (JP); Yamamoto, Makoto, c/o YOZAN Inc., Tokyo 155 (JP)
(74) Representative: Grünecker, Kinkeldey, Stockmair & Schwanhäusser Anwaltssozietät

(56) References cited:
- US-A- 3 355 598
- US-A- 5 005 059
- PATENT ABSTRACTS OF JAPAN vol. 6, no. 128 (E-118)(1006) 14 July 1982 & JP-A-57 053 151
- PATENT ABSTRACTS OF JAPAN vol. 11, no. 7 (E-469) 9 January 1987 & JP-A-61 182 244
- IBM TECHNICAL DISCLOSURE BULLETIN, vol. 7, no. 11, April 1965, New York US, page 1100; M.G. SMITH : 'Device tailoring procedure'

## Description

### FIELD OF THE INVENTION

The present invention relates to a field effect transistor.

### BACKGROUND OF THE INVENTION

The development in LSI technology is very remarkable in these days, and a device of high speed, large capacity and low electricity consuming has produced one after another.

The motive power of these developments depends on the improvement of a minute processing technology. In order to make a leap of the technology in the future, a plant investment of new LSI processing will be needed. The necessary cost for creating a plant investment of 1 giga bite DRAM is estimated 1, 500,000,000,000 yen: it exceeds the expendable cost of a company. As a result, the improvement of LSI technology independent of a minute processing technology is desired in the future.

Further devices are disclosed in Pat. Abs. Jap vol. 6 no. 128 (E-116)(1006) and JP-A-5753151, Pat. Abs. Jap. vol. 11, no.7 (E-469) and JP-A- 61182244 and IBM TDB vol.7 no.11 Apr. 1965, pq.1100.

Under such a condition, abandonment of Neuman computers, such as research of a neural network, a highly intensive functions and multi-valuing data in LSI will be highly possibly break through, however. any decisive direction is not given concerning with them.

### SUMMARY OF THE INVENTION

The present invention as claimed in claim 1 is invented considering the state above and has an object to provide a field effect transistor realizing highly intensive functions in a LSI.

A field effect transistor relating to the present invention has a plural number of gates, and it generates an output by totalizing characteristics of "gate voltage vs. drain current" of the gates.

### BRIEF DESCRIPTION OF THE DRAWINGS

Figure 1 shows a plane pattern in an embodiment of a field effect transistor relating to the present invention.

Figure 2 shows vertical cross section of the embodiment.

Figure 4 is a graph showing a characteristic of drain current of the field effect transistor of the embodiment.

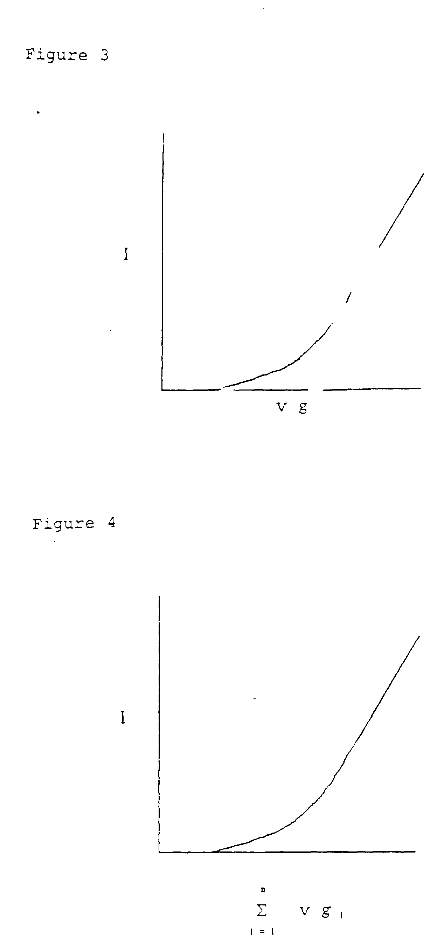

Figure 3 is a graph showing a characteristic of a drain current of a conventional field effect transistor.

### PREFERRED EMBODIMENT OF THE PRESENT INVENTION

Hereinafter, an embodiment of a field effect transistor relating to this invention is described with reference to the attached drawings.

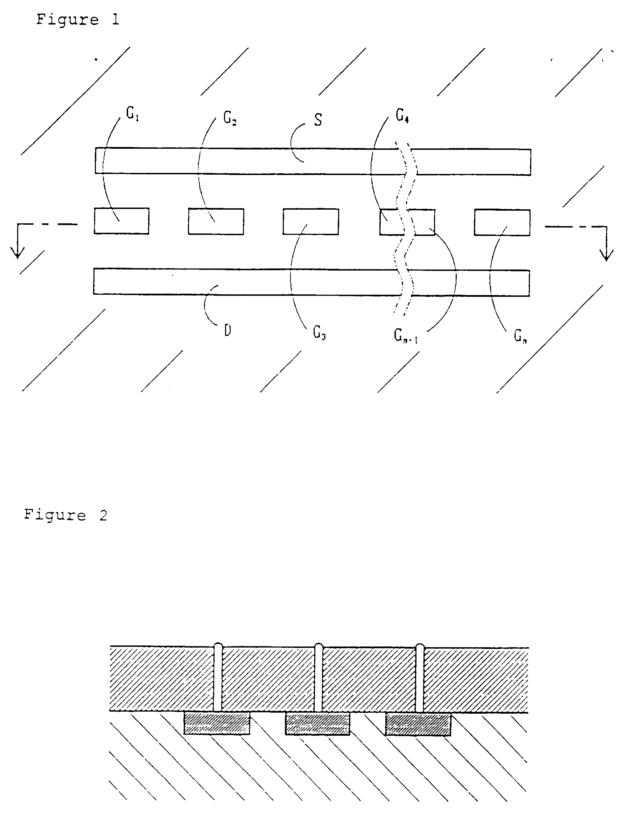

Figure 1 is a plane pattern of a field effect transistor of this invention, where a plural number of gates G1, G2....and Gn are set between source S and drain D. A conductor for impressing voltage to each gate is led upward, and the electricity is given from the upper positioned layer (Figure 2). There is no interference of both of source S and drain D positioning in both sides of the gate, and the gate can be given electricity.

When a characteristic function of drain current vs. a gate voltage vg of a gate is defined as I(vg), then the characteristic of the plural number of gates is defined as
n
ΣI (vgi)
i = 1
vgi : i-th gate voltage.
These characteristics are shown in graphs in Figure 3 and Figure 4.

As a result, a field effect transistor has an additional function in itself and realizes intensive functions and high density of functions to be equipped in a LSI.

As mentioned above, a field effect transistor relating to this invention establishes a plural number of gates and generates an output by totalizing of characteristics of "gate voltage vs. drain current" of the gates, so it has an effective result realizable a highly intensive function.

## Claims

1. A field effect transistor in a large-scale integrated circuit comprising a common source region, a common drain region and a plurality of gates located in parallel between the common source region and said common drain region, characterised in that each gate is connected to an independent analog voltage source which controls the forming of an independent channel in between said common source region and said common drain region and below the respective gate thus controlling, independently from the other voltages applied to the other gates, the flow of a current between said common source region and said common drain region.

## Patentansprüche

1. Feldefeffekttransistor in einem hochintegrierten Schaltkreis mit einem gemeinsamen Source-Bereich, einem gemeinsamen Drain-Bereich und einer Vielzahl von Gatebereichen, die parallel zwischen dem gemeinsamen Source-Bereich und dem gemeinsamen Drain-Bereich angeordnet sind,
dadurch gekennzeichnet, daß
jedes Gate an eine unabhängige analoge Spannungsquelle angeschlossen ist, die die Bildung eines unabhängigen Kanals zwischen dem gemeinsamen Source-Bereich und dem gemeinsamen Drain-Bereich sowie unterhalb des jeweiligen Gates bildet, wodurch der Stromfluß zwischen dem gemeinsamen Source-Bereich und dem gemeinsamen Drain-Bereich unabhängig von den an den anderen Gatebereichen anliegenden Spannungen gesteuert wird.

## Revendications

1. Transistor à effet de champ dans un circuit intégré à grande échelle comprenant une région de source commune, une région de drain commune et une pluralité de grilles placées en parallèle entre la région de source commune et ladite région de drain commune, caractérisé en ce que chaque grille est connectée à une source de tension analogique indépendante qui commande la formation d'un canal indépendant entre ladite région de source commune et ladite région de drain commune et au-dessous de la grille respective, commandant ainsi, indépendamment des autres tensions appliquées aux autres grilles, le passage d'un courant entre ladite région de source commune et ladite région de drain commune.
